# EUROPEAN PATENT APPLICATION

(11) **EP 4 468 840 A1**
(43) Date of publication of application: **27.11.2024**
(21) Application number: 24156232.1
(22) Date of filing: 07.02.2024
(51) Int. Cl.: H10B 12/00

(54) **SEMICONDUCTOR MEMORY DEVICE**

(30) Priority: 24.05.2023 KR 20230066923
(71) Applicant: Samsung Electronics Co., Ltd., Suwon-si, Gyeonggi-do 16677 (KR)
(72) Inventor: SHIN, Sooho, 16677 Suwon-si (KR); CHANG, Jihoon, 16677 Suwon-si (KR)
(74) Representative: Marks & Clerk LLP

(57) **Abstract**

A semiconductor device includes a device isolation pattern defining active portions extending in a first direction, a first bit line intersecting the active portions in a second direction, a second bit line spaced apart from the first bit line in a third direction, bit line capping patterns on the bit lines, a storage node contact between the bit lines, a diffusion barrier layer on sidewalls of bit lines and on a top of the storage node contact, and a landing pad on the diffusion barrier layer. A first upper end of the diffusion barrier layer on the sidewall of the first bit line is lower than the bit line capping patterns, and a second upper end of the diffusion barrier layer on the sidewall of the second bit line is lower than the first upper end.

## Description

### FIELD

The present disclosure relates to a semiconductor memory device and a method of fabricating the same.

### BACKGROUND

Semiconductor devices are attractive in the electronic industry because of the relatively small size, multi-functional characteristics and/or low fabrication cost thereof. As the electronic industry becomes highly integrated, semiconductor devices have been more and more highly integrated. The line widths of the semiconductor devices have been gradually reduced to increase the integration density of the semiconductor devices. However, there may be some limitations in increasing the integration density of the semiconductor devices because new exposure techniques and/or high cost for the new exposure techniques may be required in reduction of the line widths. Accordingly, research on new integration technologies have been conducted.

### SUMMARY

Embodiments of the present disclosure provide a semiconductor memory device with improved reliability.

Embodiments of the present disclosure provide a method of fabricating a semiconductor memory device capable of improving yield.

A semiconductor memory device according to some embodiments of the present disclosure includes a substrate having active portions extending in a first direction, the active portions comprising first and second impurity regions at central and edge portions thereof, respectively; a device isolation pattern in the substrate between the active portions; a first bit line connected to at least one of the first impurity regions and extending over the active portions in a second direction that intersects the first direction; a second bit line spaced apart from the first bit line in a third direction that intersects the first and second directions; first and second bit line capping patterns on the first and second bit lines, respectively; a storage node contact between the first bit line and the second bit line and in contact with one of the second impurity regions; a diffusion barrier layer on a sidewall of the first bit line, on a sidewall of the second bit line, and on an upper surface of the storage node contact therebetween; and a landing pad on the diffusion barrier layer. A first upper end of the diffusion barrier layer on the sidewall of the first bit line is lower than the first bit line capping pattern, relative to the substrate, and a second upper end of the diffusion barrier layer on the sidewall of the second bit line is lower than the first upper end, relative to the substrate.

A semiconductor memory device according to some embodiments of the present disclosure includes a substrate having active portions that extend in a first direction, the active portions comprising first and second impurity regions at central and edge portions thereof, respectively; a device isolation pattern in the substrate between the active portions; a first bit line connected to at least one of the first impurity regions and extending over the active portions in a second direction that intersects the first direction; a second bit line spaced apart from the first bit line in a third direction that intersects the first and second directions; first and second bit line capping patterns on the first and second bit lines, respectively; a storage node contact between the first bit line and the second bit line and in contact with one of the second impurity regions; a diffusion barrier layer on a sidewall of the first bit line, on a sidewall of the second bit line, and on an upper surface of the storage node contact therebetween, wherein upper sidewalls of the first and second bit line capping patterns are free of the diffusion barrier layer; and a landing pad on the diffusion barrier layer. The landing pad comprises a first pad portion on the diffusion barrier layer; and a second pad portion on the first pad portion and in contact with the first bit line capping pattern. The first pad portion comprises chlorine atoms, and the second pad portion is free of chlorine atoms.

A semiconductor memory device according to some embodiments of the present disclosure includes a substrate having active portions extending in a first direction, the active portions comprising first and second impurity regions at central and edge portions thereof, respectively; a device isolation pattern in the substrate between the active portions; word lines in the substrate and intersecting the active portions in a second direction that intersects the first direction; word line capping patterns on the word lines; a first bit line connected to at least one of the first impurity region and extending over the word lines in a third direction that intersects the first and second directions; a second bit line spaced apart from the first bit line in the second direction; first and second bit line capping patterns on the first and second bit lines, respectively; a storage node contact between the first bit line and the second bit line and in contact with one of the second impurity regions; a diffusion barrier layer on a sidewall of the first bit line, on a sidewall of the second bit line, and on an upper surface of the storage node contact therebetween, wherein upper sidewalls of the first and second bit line capping patterns are free of the diffusion barrier layer; and a landing pad on the diffusion barrier layer. The landing pad comprises a first pad portion on the diffusion barrier layer; and a second pad portion on the first pad portion and in contact with the first bit line capping pattern. The first pad portion comprises first metal grains having a first average size, and the second pad portion comprises second metal grains having a second average size smaller than the first average size.

A method of fabricating a semiconductor memory device according to some embodiments of the present disclosure includes forming a device isolation pattern on a substrate to define active portions; forming first impurity regions and second impurity regions in the active portions; forming bit lines on the substrate extending over the active portions and in contact with at least one of the first impurity regions; forming bit line capping patterns on the bit lines; forming spacer structures on sidewalls of the bit lines and the bit line capping patterns; forming storage node contacts between the bit lines and in contact with the second impurity regions, respectively; forming a diffusion barrier layer on the substrate after forming the spacer structures and the storage node contacts; forming a first pad layer on the diffusion barrier layer in spaces between the bit line capping patterns; performing an anisotropic etching process on the first pad layer and the diffusion barrier layer to form a diffusion barrier patterns and first pad patterns, wherein upper surfaces of the bit line capping patterns and upper sidewalls of the spacer structures are free of the diffusion barrier patterns; forming a second pad layer on the substrate after performing the anisotropic etching process; and patterning the second pad layer to form second pad patterns on the first pad patterns to form landing pads.

According to various embodiments, a diffusion barrier layer may be formed with first upper end that is lower than a first bit line capping pattern, relative to the substrate. For instance, the first upper end may be lower than an upper end of the first bit line capping pattern. This can help prevent

At least some of the above and other features of the invention are set out in the claims.

### BRIEF DESCRIPTION OF THE DRAWINGS

Example embodiments will be more clearly understood from the following brief description taken in conjunction with the accompanying drawings. The accompanying drawings represent non-limiting, example embodiments as described herein.
FIG. 1 is a plan view of a semiconductor device according to embodiments of the present disclosure.
FIG. 2 is a cross-sectional view of FIG. 1 taken along lines A-A' and lines B-B'.
FIGS. 3A, 3B, 3C, 3D, and 3E are enlarged views of the 'P1' portion of FIG. 2 according to embodiments of the present disclosure.
FIGS. 4A, 4B, 4C, 4D, 4E, 4F, 4G, 4H, 4I, and 4K are cross-sectional views sequentially illustrating a process of fabricating a semiconductor device having the cross-sections of FIG. 2 according to embodiments of the present disclosure.
FIG. 5 is a plan view of a semiconductor memory device according to embodiments of the present disclosure.
FIG. 6 is a cross-sectional view of FIG. 5 taken along lines A-A' and lines B-B'.

### DETAILED DESCRIPTION

Hereinafter, to explain the present disclosure in more detail, embodiments according to the present disclosure will be described with reference to the accompanying drawings. Herein, a storage node contact, a storage node pattern, a landing pad, a diffusion barrier pattern, a first pad pattern, a second pad pattern, and so on may be respectively referred to as a 'conductive pattern' or a 'conductive contact', and may be named 'first', 'second', and so on depending on an order in which they are mentioned. Herein, word lines and bit lines may be respectively referred to as 'conductive lines', and may be named 'first', 'second', and so on depending on an order in which they are mentioned. The terms "first," "second," etc., may be used herein merely to distinguish one component, layer, direction, etc. from another. The terms "comprises," "comprising," "includes" and/or "including," when used herein, specify the presence of stated elements, but do not preclude the presence of additional elements. The term "and/or" includes any and all combinations of one or more of the associated listed items. The term "connected" may be used herein to refer to a physical and/or electrical connection. When components or layers are referred to as "directly on" or "directly connected", no intervening components or layers are present. Likewise, when components are "immediately" adjacent to one another, no intervening components may be present.

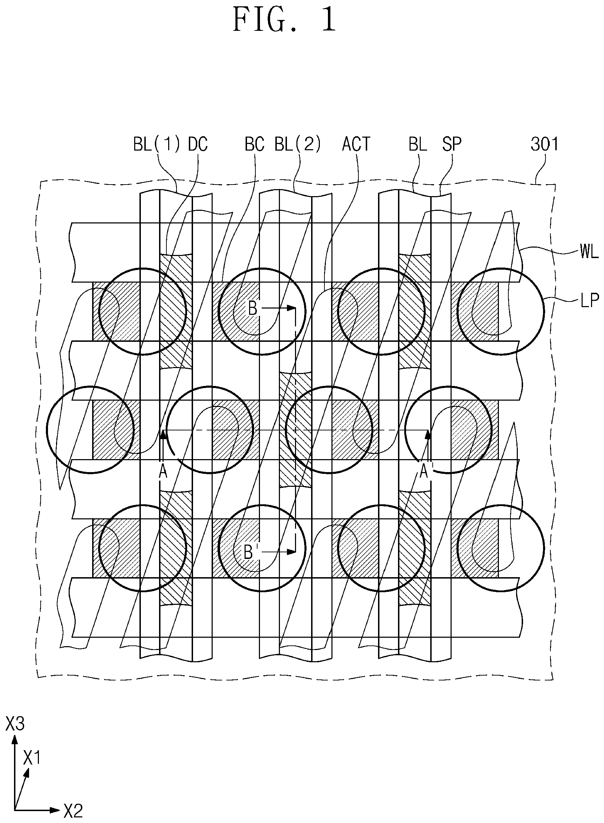

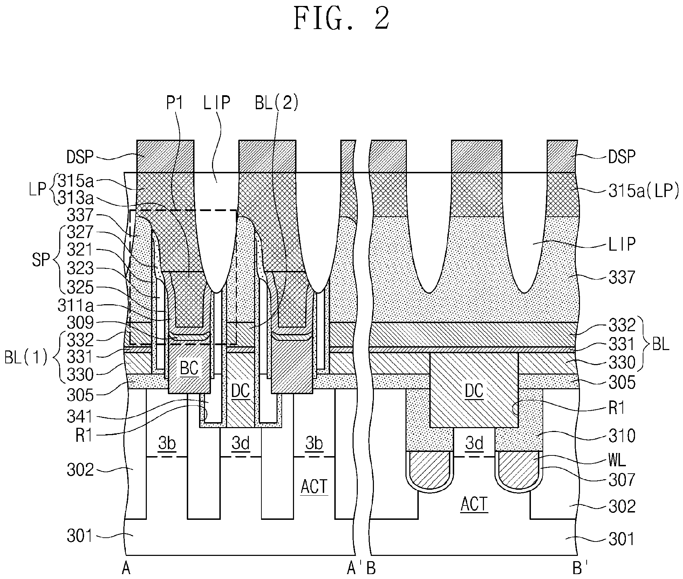

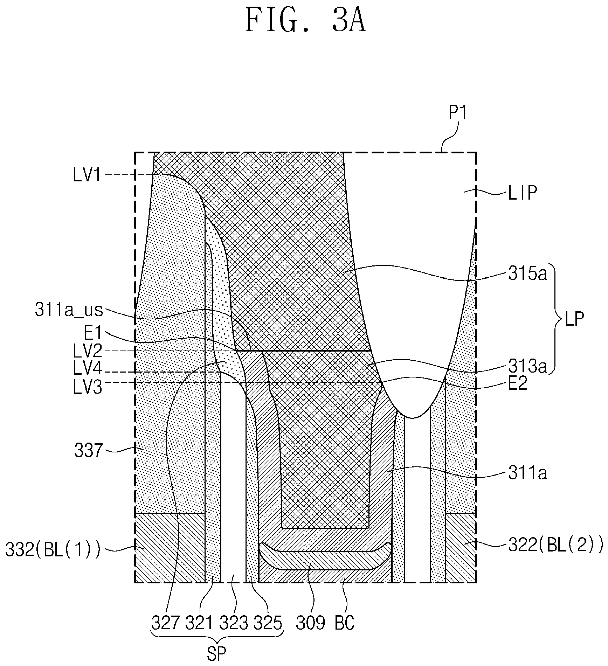

FIG. 1 is a plan view of a semiconductor device according to embodiments of the present disclosure. FIG. 2 is a cross-sectional view of FIG. 1 taken along lines A-A' and lines B-B'. FIGS. 3A to 3E are enlarged views of the 'P1' portion of FIG. 2 according to embodiments of the present disclosure.

Referring to FIGS. 1 and 2, device isolation patterns 302 may be disposed on a substrate 301 to define active portions ACT. Each of the active portions ACT may have an isolated shape. Each of the active portions ACT may have an elongated shape in a first direction X1 (e.g. a bar shape that is planarly elongated in the first direction X1). The first direction X1 may be parallel to an upper surface of the substrate 301 (e.g. the first direction X1 may be a horizontal direction). When viewed in a plan view, the active portions ACT may respectively correspond to portions of the substrate 301 surrounded by the device isolation patterns 302. The substrate 301 may include a semiconductor material. The term "surround" or "cover" or "fill" as may be used herein may not require completely surrounding or covering or filling the described elements or layers, but may, for example, refer to partially surrounding or covering or filling the described elements or layers. The active portions ACT may be arranged parallel to each other in the first direction X1, and an end of one active portion ACT may be arranged adjacent to a center of another active portions ACT adjacent thereto.

Word lines WL may cross (i.e., intersect) the active portions ACT. The word lines WL may be disposed in grooves formed in the device isolation patterns 302 and the active portions ACT. The word lines WL may be parallel to a second direction X2 crossing the first direction X1. The second direction X2 may be parallel to an upper surface of the substrate 301 (e.g. the second direction X2 may be a horizontal direction). The word lines WL may be formed of a conductive material. A gate dielectric layer 307 may be disposed between each of the word lines WL and inner surfaces of each of the grooves. Although not shown, bottoms of the grooves may be relatively deep within the device isolation patterns 302 and relatively shallow within the active portions ACT. The gate dielectric layer 307 may include at least one of thermal oxide, silicon nitride, silicon oxynitride, and a high dielectric material. Lower surfaces of the word lines WL may be curved or non-planar.

A first impurity region 3d may be disposed in each of the active portions ACT between the pair of word lines WL, and a pair of second impurity regions 3b may be respectively disposed in both edge regions (e.g. end regions) of each of the active portions ACT. The first and second impurity regions 3d and 3b may be doped with, for example, N-type impurities. Each of the word lines WL and the first and second impurity regions 3d and 3b adjacent thereto may constitute a transistor. As the word lines WL are disposed in the grooves, a channel length of a channel region under the word lines WL may be increased within a limited planar area. Therefore, a short-channel effect and the like may be reduced or minimized.

A height direction may be defined as a direction perpendicular to the upper surface of the substrate 301. The height may be relative to the substrate 301 (e.g. relative to an upper surface of the substrate 301). Features that are "higher" or "above" other features may be features that are further away from the substrate 301 (e.g. the upper surface of the substrate 301) than the other features. Similarly, features that are "lower" or "below" other features may be features that are closer to the substrate 301 (e.g. the upper surface of the substrate 301) than the other features.

Upper surfaces of the word lines WL may be lower than upper surfaces of the active portions ACT. A word line capping pattern 310 may be disposed on each of the word lines WL. The word line capping patterns 310 may have a linear or line shape extending in a length direction of the word lines WL, and may cover the entire upper surfaces of the word lines WL. The word line capping patterns 310 may fill the grooves on the word lines WL. The word line capping pattern 310 may be formed of, for example, a silicon nitride layer.

An interlayer insulating pattern 305 may be disposed on the substrate 301. The interlayer insulating pattern 305 may be formed of at least one single layer or multiple layers selected from a silicon oxide layer, a silicon nitride layer, and a silicon oxynitride layer. The interlayer insulating patterns 305 may be formed in a form of islands spaced apart from each other when viewed in a plan view. The interlayer insulating pattern 305 may be formed to simultaneously cover end portions of two adjacent active portions ACT.

Upper portions of the substrate 301, the device isolation pattern 302, and the word line capping pattern 310 may be partially recessed to form a first recess region R1. The first recess region R1 may have a mesh shape when viewed in a plan view. A sidewall of the first recess region R1 may be aligned with a sidewall of the interlayer insulating pattern 305.

Bit lines BL may be disposed on the interlayer insulating pattern 305. The bit lines BL may cross the word line capping patterns 310 and the word lines WL. As shown in FIG. 1, the bit lines BL may be parallel to a third direction X3 crossing the first and second directions X1 and X2. The third direction X3 may be parallel to an upper surface of the substrate 301 (e.g. the third direction X3 may be a horizontal direction). The bit lines BL may include a bit line polysilicon pattern 330, a first metal pattern 331, and a second metal pattern 332 sequentially stacked. The bit line polysilicon pattern 330 may include polysilicon doped with impurities. The first metal pattern 331 may include a single layer or multilayer structure of at least one of titanium, titanium nitride, tantalum, tantalum nitride, tungsten nitride, cobalt silicide, and titanium silicide. The second metal pattern 332 may include metal (e.g., tungsten, titanium, tantalum, etc.). A bit line capping pattern 337 may be disposed on each of the bit lines BL. The bit line capping patterns 337 may be formed of an insulating material such as silicon nitride.

Bit line contacts DC may be disposed in the first recess region R1 crossing the bit lines BL. The bit line contacts DC may include polysilicon doped with impurities. In the B-B' cross section of FIG. 2, one sidewall of the bit line contact DC may be in contact with a sidewall of the interlayer insulating pattern 305. Referring to a plan view of FIG. 1, one side surface of the bit line contact DC may be concave. The bit line contact DC may electrically connect the first impurity region 3d and the bit line BL.

A lower buried insulating pattern 341 may be disposed in the first recess region R1 where the bit line contact DC is not disposed. The lower buried insulating pattern 341 may be formed of at least one single layer or multiple layers selected from a group including a silicon oxide layer, a silicon nitride layer, and a silicon oxynitride layer.

Storage node contacts BC may be disposed between a pair of adjacent bit lines BL(1) and BL(2). The storage node contacts BC may be spaced apart from each other. The storage node contacts BC may include polysilicon doped or undoped with impurities. Upper surfaces of the storage node contacts BC may be concave. An insulating pattern (not shown) may be disposed between the bit lines BL and the storage node contacts BC.

A spacer structure SP may be interposed between the bit line BL and the storage node contact BC. The spacer structure SP may extend along the side of the bit line BL in the third direction X3 when viewed in the plan view of FIG. 1.

The spacer structure SP may include first to fourth spacers 321, 323, 325, and 327. The first spacer 321 covers side surfaces of the bit line BL and the bit line capping pattern 337. The first spacer 321 may extend to cover an inner wall and a bottom surface of the first recess region R1. The second spacer 323 may cover a lower sidewall of the first spacer 321 while exposing an upper sidewall thereof. The first spacer 321 may extend to cover a lower surface of the second spacer 323. The third spacer 325 may cover a side surface of the second spacer 323. One lower end of the first spacer 321 may be in contact with the third spacer 325. The fourth spacer 327 may cover the upper sidewall of the first spacer 321 and the upper surface of the second spacer 323. The second spacer 323 may include a material different from that of the first spacer 321, the third spacer 325, and the fourth spacer 327. For example, the first spacer 321, the third spacer 325, and the fourth spacer 327 may be formed of silicon nitride. The second spacer 323 may be formed of silicon oxide. Alternatively, the second spacer 323 may be an air gap region. An upper width of the spacer structure SP is narrower than a lower width. Accordingly, a formation margin of the subsequent landing pad LP may be increased. Therefore, it is possible to reduce or prevent a connection failure between the landing pad LP and the storage node contact BC.

Although not shown, node separation patterns may be disposed between storage node contacts BC spaced apart from each other in the third direction X3 between adjacent bit lines BL(1) and BL(2). The node separation patterns may overlap the word lines WL. Components or layers described with reference to "overlap" in a particular direction may be at least partially obstructed by one another when viewed along a line extending in the particular direction or in a plane perpendicular to the particular direction. That is, components or layers described as "overlapping" in a particular direction may be arranged such that a line running along that particular direction can be positioned so that it crosses through at least a portion of each of the components or layers. The storage node contacts BC may include at least one single layer or multilayer structure of an insulating material, preferably of silicon oxide, silicon nitride and/or silicon oxynitride. The first to third spacers 321, 323, and 325 of the spacer structure SP may be interposed between the node separation patterns and the bit lines BL. Upper surfaces of the node separation patterns may be coplanar with an upper surface of the bit line capping pattern 337. The first to third spacers 321, 323, and 325 may extend and be interposed between the node separation patterns and the bit line capping pattern 337.

Referring to FIG. 3A, a storage node ohmic layer 309 is disposed on the storage node contact BC. The storage node ohmic layer 309 may include metal silicide. An upper surface of the storage node ohmic layer 309 and a lower side surface of the spacer structure SP may be conformally covered with a diffusion barrier pattern 311a. The diffusion barrier pattern 311a may cover lower side surfaces of the node separation patterns. The diffusion barrier pattern 31 1a may include a single layer structure or a multilayer structure of at least one of titanium, titanium nitride, tantalum, tantalum nitride, and tungsten nitride.

Referring to FIG. 3A, an upper end of the bit line capping pattern 337 may have a first level LV1. The diffusion barrier pattern 311a may have a first upper end E1 at the side of the first bit line BL(1) and a second upper end E2 at the side of the second bit line BL(2). The first upper end E1 may be on an opposite end of the diffusion barrier pattern 311a to the second end E2. The first upper end E1 may have a second level LV2 lower than the first level LV1. The second upper end E2 may have a third level LV3 lower than the second level LV2. An upper end of the second spacer 323 may have a fourth level LV4. The fourth level LV4 may be lower than the second level LV2. The fourth level LV4 may be higher than the third level LV3. The term "level" may be used herein to describe relative distances of elements or layers with respect to a reference surface (e.g., the substrate 301). For instance, the various "levels" described herein may relate to relative distances measured from the substrate 301 (e.g. the upper surface of the substrate 301) along a vertical direction (e.g. a direction perpendicular to the upper surface of the substrate 301).

In another example, when the fourth spacer 327 completely covers the upper surface of the second spacer 323 and the fourth spacer 327 comes into contact with the third spacer 325, the fourth level LV4 may be higher than the second level LV2. The first upper end E1 of the diffusion barrier pattern 311a may have a flat or substantially planar upper surface 311_us.

In the semiconductor memory device according to the present disclosure, both the first upper end E1 and the second upper end E2 of the diffusion barrier pattern 311a are lower than the upper end of the bit line capping pattern 337. Accordingly, it is possible to prevent bridging between adjacent landing pads LP by the diffusion barrier pattern 311a. Accordingly, an operation error of the semiconductor memory device may be reduced or prevented and a semiconductor memory device with improved reliability may be provided.

Referring to FIG. 3A, a landing pad LP is disposed on the diffusion barrier pattern 311a. The landing pad LP may be formed of a metal-containing material such as tungsten. A center of the landing pad LP (or a second pad pattern 315a) may shift from a center of the storage node contact BC in the second direction X2. A portion of the bit line BL may vertically overlap the landing pad LP. The landing pad LP may include a first pad pattern 313a and a second pad pattern 315a thereon. The first pad pattern 313a and the second pad pattern 315a may include the same metal (e.g., tungsten). There may be no interface between the first pad pattern 313a and the second pad pattern 315a. In other words, the first pad pattern 313a and the second pad pattern 315a may define a unitary structure. In another example, the first pad pattern 313a and the second pad pattern 315a may include different metals.

Referring to FIG. 3A, a side surface and a lower surface of the first pad pattern 313a may be covered with the diffusion barrier pattern 311a. An upper surface of the first pad pattern 313a may be coplanar with the upper surface 311_us of the first upper end E1 of the diffusion barrier pattern 311a. The second pad pattern 315a may be on an upper surface of the first pad pattern 313a. The second pad pattern 315a may be in contact with an upper sidewall of the spacer structure SP and an upper surface of the bit line capping pattern 337. The first pad pattern 313a may include chlorine (Cl) atoms. The second pad pattern 315a may exclude (i.e., may be free of) chlorine atoms. When the second pad pattern 315a excludes chlorine atoms, an electrical resistance of the second pad pattern 315a may be reduced, and signal transmission may be accelerated, thereby improving an operating speed of the semiconductor memory device.

In another example, the second pad pattern 315a may also include chlorine atoms. In this case, a content (or atomic concentration) of chlorine (Cl) atoms included in the first pad pattern 313a may be different from a content (or atomic concentration) of chlorine atoms included in the second pad pattern 315a. For instance, the content (or atomic concentration) of chlorine (Cl) atoms included in the second pad pattern 315a may be less than a content (or atomic concentration) of chlorine atoms included in the first pad pattern 313a.

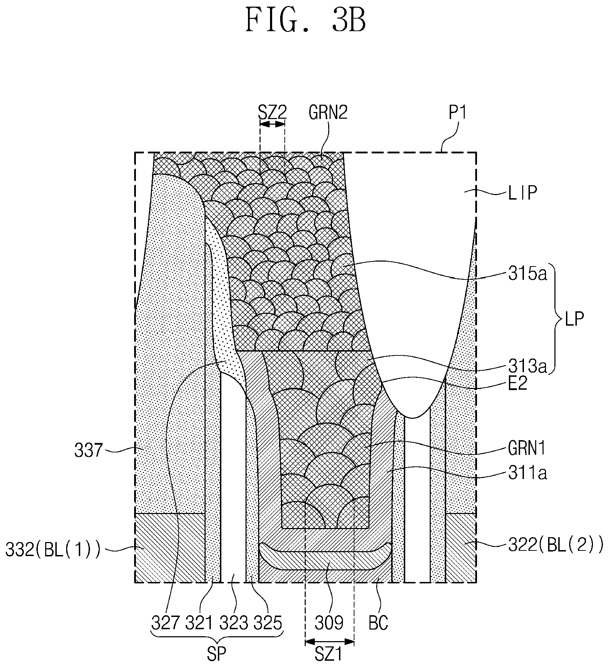

In another example, referring to FIG. 3B, the first pad pattern 313a may include first metal grains GRN1. The second pad pattern 315a may include second metal grains GRN2. The first metal grains GRN1 and the second metal grains GRN2 may include the same metal atoms (e.g. metal atoms of the same material/metal). The first metal grains GRN1 may have a first average size SZ1. The second metal grains GRN2 may have a second average size SZ2 smaller than the first average size SZ1. The term "size" as used herein may refer to one or more dimensions.

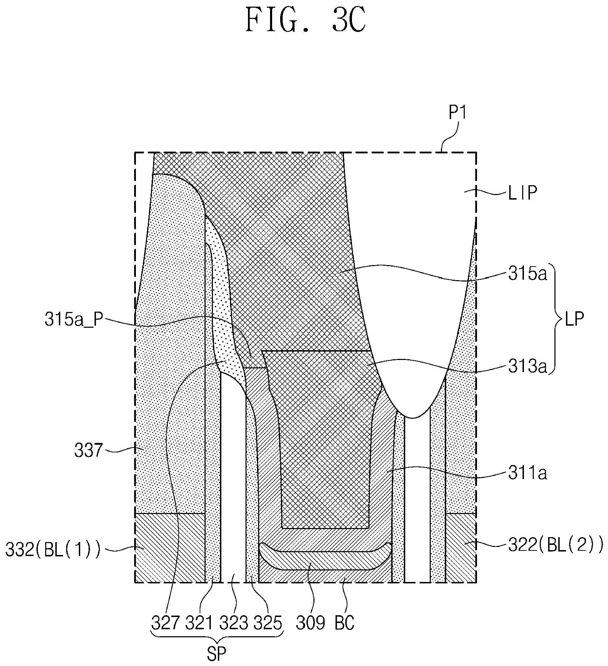

In another example, referring to FIG. 3C, a first upper end E1 of the diffusion barrier pattern 311a may be lower than an upper surface of the first pad pattern 313a. A portion 315_P of the second pad pattern 315a may be interposed between an upper side surface of the first pad pattern 313a and the spacer structure SP.

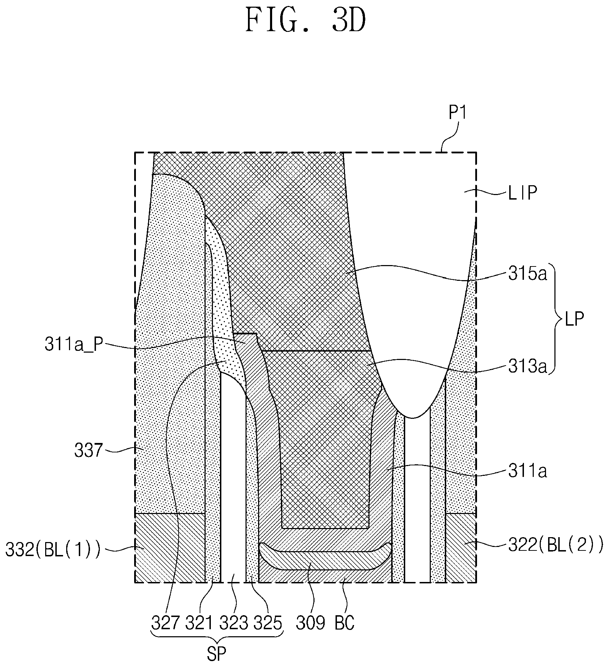

In another example, referring to FIG. 3D, a first upper end E1 of the diffusion barrier pattern 311a may be higher than an upper surface of the first pad pattern 313a. A portion 311a_P of the diffusion barrier pattern 311a may be interposed between the second pad pattern 315a and the spacer structure SP.

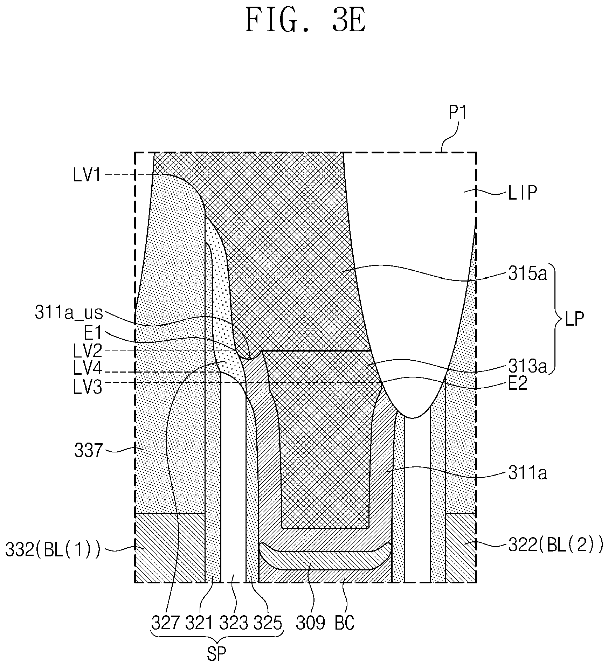

In another example, referring to FIG. 3E, the upper surface 311a_us of the first upper end E1 of the diffusion barrier pattern 311a may be recessed to have a rounded concave downward profile.

A landing pad separation pattern LIP may be disposed between the landing pads LP to separate the landing pads LP from each other. A portion of the landing pad separation pattern LIP may pass through a portion of the bit line capping pattern 337. A portion of the landing pad separation pattern LIP may pass through the fourth spacer 327 adjacent to the bit line contact DC and may be in contact with an upper portion of the second spacer 323. The landing pad separation pattern LIP may include a single layer structure or a multilayer structure of at least one of a silicon nitride layer, a silicon oxide layer, a silicon oxynitride layer, and a porous layer.

A data storage pattern DSP may be disposed on the landing pads LP. The data storage pattern DSP may be a capacitor including a lower electrode, a dielectric layer, and an upper electrode. In this case, the semiconductor memory device may be a dynamic random-access memory (DRAM). Alternatively, the data storage patterns DSP may include a magnetic tunnel junction pattern. In this case, the semiconductor memory device may be a magnetic random access memory (MRAM). Alternatively, the data storage patterns DSP may include a phase change material or a variable resistance material. In this case, the semiconductor memory device may be a phase-change random access memory (PRAM) or a resistive RAM (ReRAM).

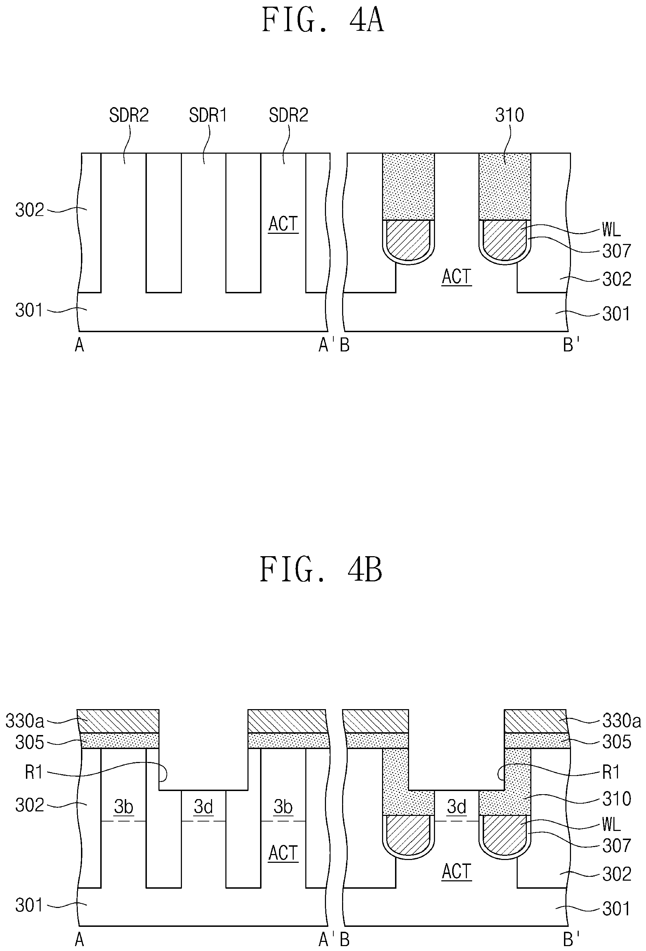

FIGS. 4A to 4K are cross-sectional views sequentially illustrating a process of fabricating a semiconductor device having the cross-sections of FIG. 2 according to embodiments of the present disclosure.

Referring to FIG. 4A, device isolation patterns 302 may be formed on a substrate 301 to define active portions ACT. A device isolation trench may be formed in the substrate 301, and the device isolation patterns 302 may fill the device isolation trench. The active portions ACT and the device isolation patterns 302 may be patterned to form grooves. In this case, etching conditions for the substrate 301 and the device isolation patterns 302 may be adjusted so that the device isolation patterns 302 are more etched than the substrate 301. As a result, bottom surfaces of the grooves may be curved.

Word lines WL may be formed in the grooves, respectively. A pair of the word lines WL may cross (i.e., intersect) each of the active portions ACT. As shown in FIG. 1 and FIG. 4A, each of the active portions ACT may be divided into a first source/drain region SDR1 and a pair of second source/drain regions SDR2 due to the pair of word lines WL. The first source/drain region SDR1 may be defined between the pair of word lines WL, and the pair of second source/drain regions SDR2 may be defined in each at both edge regions (e.g. end regions) of the active portions ACT.

Before forming the word lines WL, a gate dielectric layer 307 may be formed on inner surfaces of the grooves. The gate dielectric layer 307 may be formed through a thermal oxidation process, a chemical vapor deposition process, and/or an atomic layer deposition process. A gate conductive layer may be deposited to fill the grooves, and then the word lines WL may be formed by etching back. Upper surfaces of the word lines WL may be recessed lower than upper surfaces of the active portions ACT. An insulating layer such as, for example, a silicon nitride layer may be deposited on the substrate 301 to fill the grooves and then etched to form a word line capping pattern 310 on each of the word lines WL.

Referring to FIG. 4B, dopants may be implanted into the active regions ACT using the word line capping patterns 310 and the device isolation pattern 302 as masks to form first and second impurity regions 3d, 3b. The first impurity region 3d and the second impurity regions 3b may be formed in the first source/drain region SDR1 and the second source/drain regions SDR2 of FIG. 4A, respectively. An insulating layer and a first polysilicon layer may be sequentially deposited on the entire surface of the substrate 301. The first polysilicon layer may be patterned to form a polysilicon mask pattern 330a. The insulating layer, the device isolation pattern 302, the substrate 301, and the word line capping pattern 310 may be etched using the polysilicon mask pattern 330a as an etch mask to form a first recess region R1 and to form an interlayer insulating pattern 305, simultaneously. The interlayer insulating pattern 305 may be formed in a form of a plurality of islands spaced apart from each other. The interlayer insulating pattern 305 may be formed to simultaneously cover end portions of two adjacent active portions ACT. The first recess region R1 may be formed in a mesh shape when viewed in a plan view. The first recess region R1 may expose the first impurity regions 3d. The term "expose" may be used to describe relationships between elements and/or certain intermediate processes in fabricating a completed semiconductor device, but is not intended to necessarily require exposure of the particular region, layer, structure or other element in the completed device.

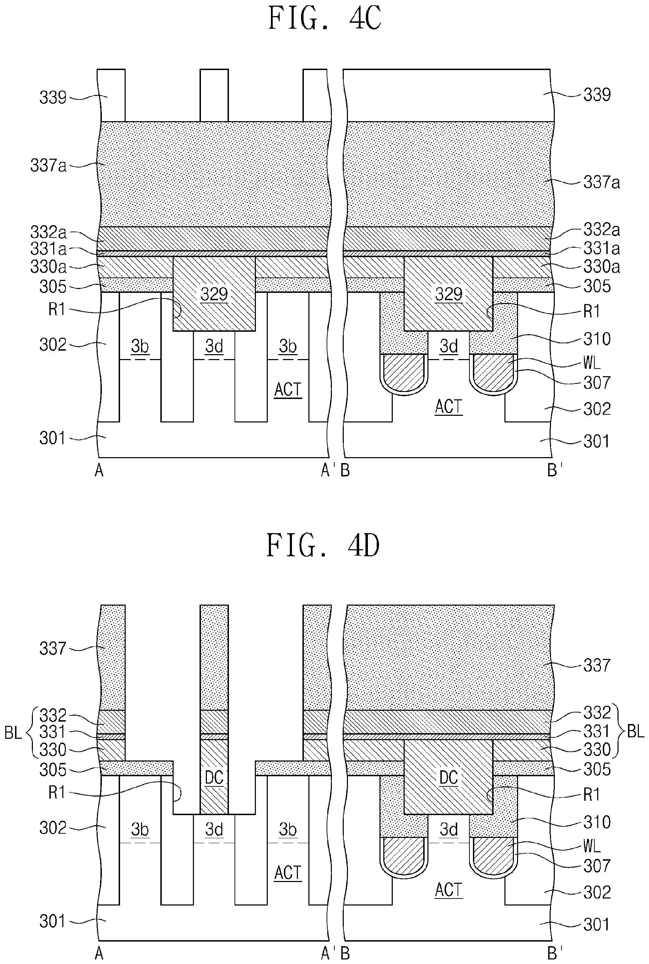

Referring to FIG. 4C, a second polysilicon layer 329 may be deposited on the entire surface of the substrate 301 to fill the first recess region R1. Then, a planarization etch process may be performed on the second polysilicon layer 329 to remove the second polysilicon layer 329 on the polysilicon mask pattern 330a and to expose an upper surface of the polysilicon mask pattern 330a. A first metal layer 331a, a second metal layer 332a, and a bit line capping layer 337a may be sequentially deposited on the polysilicon mask pattern 330a and the second polysilicon layer 329. The first metal layer 331a may be formed of a single layer or multilayer structure of at least one of titanium (Ti), titanium nitride (TiN), tantalum, tantalum nitride, tungsten nitride, cobalt silicide, titanium silicide (TiSi), and titanium silicon nitride (TiSiN). The second metal layer 332a may be formed of metal (e.g., tungsten, titanium, tantalum, etc.). The bit line capping layer 337a may be formed of a single layer or a multilayer structure of silicon nitride. First mask patterns 339 may be formed on the bit line capping layer 337a. The first mask patterns 339 may extend toward a third direction X3 crossing both the first and second directions X1 and X2.

Referring to FIG. 4D, the bit line capping layer 337a, the second metal layer 332a, the first metal layer 331a, the polysilicon mask pattern 330a, and the second polysilicon layer 329 may be sequentially etched using the first mask patterns 339 as an etching mask to form a bit line BL and a bit line contact DC including a bit line polysilicon pattern 330, a first metal pattern 331 and a second metal pattern 332, and a bit line capping pattern 337. An upper surface of the interlayer insulating pattern 305 and a portion of an inner wall and a bottom surface of the first recess region R1 may be exposed. The first mask patterns 339 may be removed.

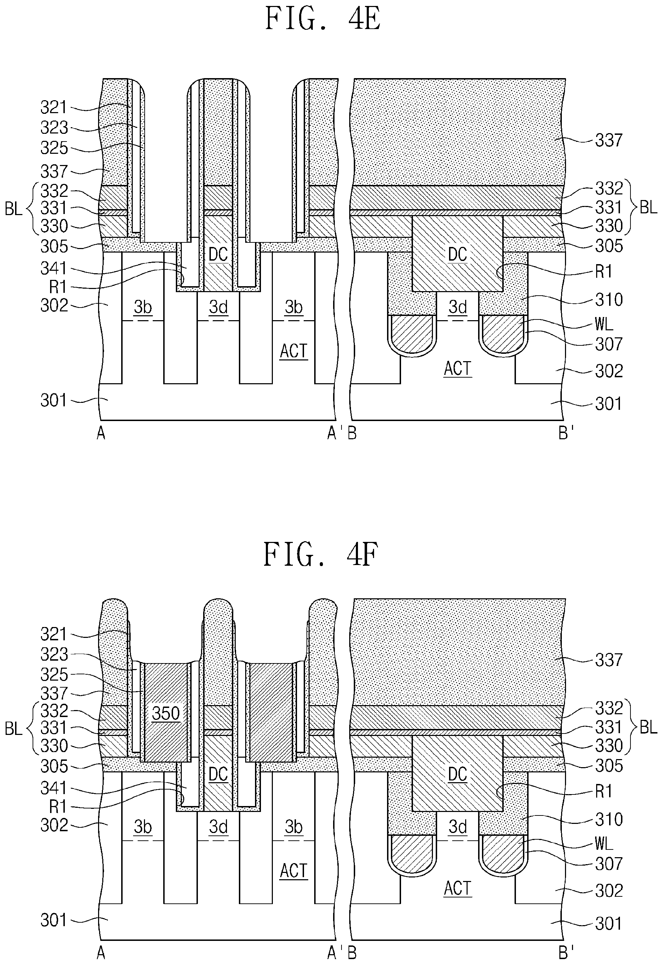

Referring to FIG. 4E, a first spacer layer may be conformally formed on the entire surface of the substrate 301. The first spacer layer may conformally cover the upper surface of the interlayer insulating pattern 305 and the bottom surface and inner wall of the first recess region R1. The first spacer layer may be, for example, a silicon nitride layer. A buried insulating layer may be deposited on the entire surface of the substrate 301 to fill the first recessed region R1, and then anisotropically etched to leave a lower buried insulating pattern 341 in the first recessed region R1. The buried insulating layer may be formed of, for example, a silicon nitride layer.

A second spacer layer may be conformally deposited on the entire surface of the substrate 301, and then an anisotropic etching process may be performed to form a second spacer 323 covering the sidewall of the first spacer 321. The second spacer 323 may have a material having an etching selectivity with that of the first spacer 321. The second spacer 323 may be formed of, for example, a silicon oxide layer. An upper surface of the interlayer insulating pattern 305 may be exposed through the anisotropic etching process for forming the second spacer 323.

A third spacer layer may be conformally deposited on the entire surface of the substrate 301, and then an anisotropic etching process may be performed to form a third spacer 325 covering sidewalls of the second spacer 323. An upper surface of the interlayer insulating pattern 305 may be exposed through the anisotropic etching process for forming the third spacer 325.

Referring to FIGS. 4E and 4F, an impurity-doped polysilicon layer may be deposited on the entire surface of the substrate 301 and fill the space between the bit lines BL and then etched, to form a spare or preliminary storage node contact 350 and to expose upper sidewalls of the first spacer 321, the second spacer 323, and the third spacer 325. The upper portions of the second spacer 323 and the third spacer 325 may be removed such that a height of upper ends of the second spacer 323 and the third spacer 325 may be similar to a height of an upper surface of a preliminary storage node contact 350. As a result, an upper sidewall of the first spacer 321 may be exposed. A width (e.g. in the second direction X2) of an upper portion of the spacer structure SP finally formed through this process may be narrower than a width of a lower portion thereof, such that a process margin may be increased when a subsequent landing pad is formed. When the upper portions of the second spacer 323 and the third spacer 325 are removed, a portion of the upper portion of the first spacer 321 may also be removed to reduce the width thereof.

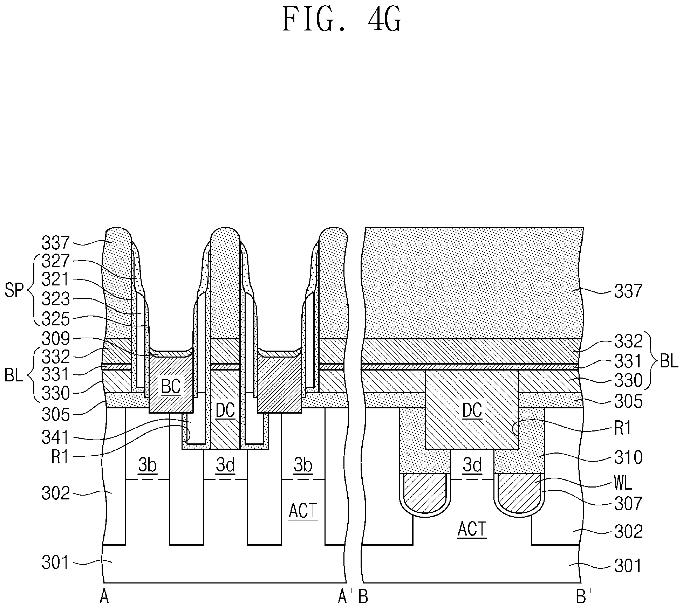

Referring to FIGS. 4F and 4G, a fourth spacer layer may be conformally deposited on the entire surface of the substrate 301 and anisotropically etched, to form a fourth spacer 327 covering the exposed upper sidewall of the first spacer 321. A lower portion of the fourth spacer 327 may cover an exposed upper portion of the second spacer 323. The preliminary storage node contact 350 may be etched to expose an upper sidewall of the third spacer 325 and to form a storage node contact BC, simultaneously. The fourth spacer 327 may reinforce the upper portion of the damaged first spacer 321 and cover the second spacer 323 (and may cover an interface between the first spacer 321 and the second spacer 323) to prevent an etchant in a process of etching the storage node contact BC and a cleaning solution in a subsequent cleaning process from penetrating into the bit line BL. Accordingly, damage to the bit line BL may be reduced or prevented.

A storage node ohmic layer 309 may be formed on an upper surface of the storage node contact BC.

The storage node ohmic layer 309 may be formed of, for example, cobalt silicide. In this case, a cobalt layer may be formed on the entire surface of the substrate 301, heat treatment may be performed to react the cobalt layer with silicon of the storage node contact BC to form a cobalt silicide layer, and then the storage node ohmic layer 309 may be formed by removing an unreacted cobalt layer.

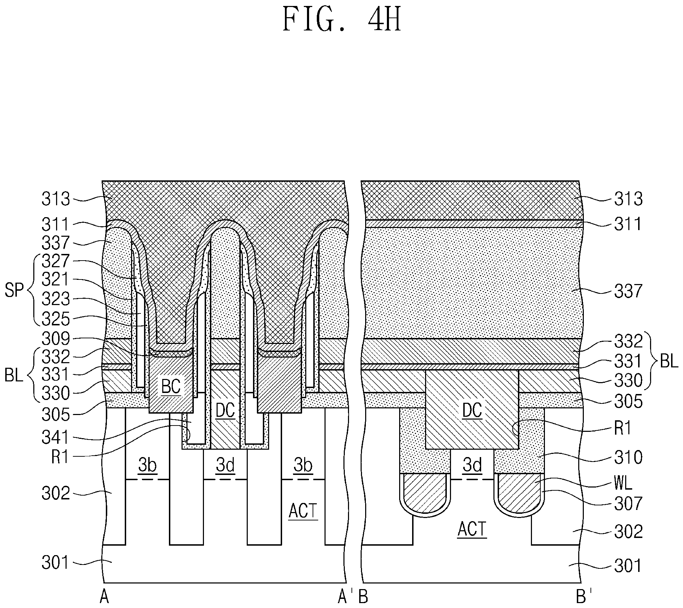

Referring to FIG. 4H, a diffusion barrier layer 311 may be conformally formed on the entire surface of the substrate 301 (e.g. after forming the storage node ohmic layer 309).

In another example, the storage node ohmic layer 309 and the diffusion barrier layer 311 may be simultaneously formed. For example, to form the diffusion barrier layer 311 on the upper surface of the storage node contact BC, a titanium layer Ti and a titanium nitride layer TiN may be sequentially and conformally deposited. In this case, Ti or TiN may react with the silicon of the storage node contact BC due to a temperature of the deposition process, and a storage node ohmic layer 309 formed of TiSi or TiSiN may be formed at an interface between the diffusion barrier layer 311 and the storage node contact BC. The diffusion barrier layer 311 may be formed by, for example, atomic layer deposition (ALD) or chemical vapor deposition (CVD).

A space between the bit line capping patterns 337 is filled by stacking a first pad layer 313 on the diffusion barrier layer 311. The first pad layer 313 may be formed by, for example, chemical vapor deposition (CVD). In the CVD process, a precursor of the first metal constituting the first pad layer 313 may be supplied as a source gas. The precursor of the first metal may include a chlorine atom. In the process of depositing the first pad layer 313, most of the chlorine atoms may be desorbed from the first metal and only the first metal atoms may be deposited, but some of the chlorine atoms may not be desorbed and may remain in the first pad layer 313. As a result, chlorine atoms may be embedded in the first pad layer 313. An upper surface of the first pad layer 313 may become flat by performing a CMP process or an etch-back process on an upper surface of the first pad layer 313.

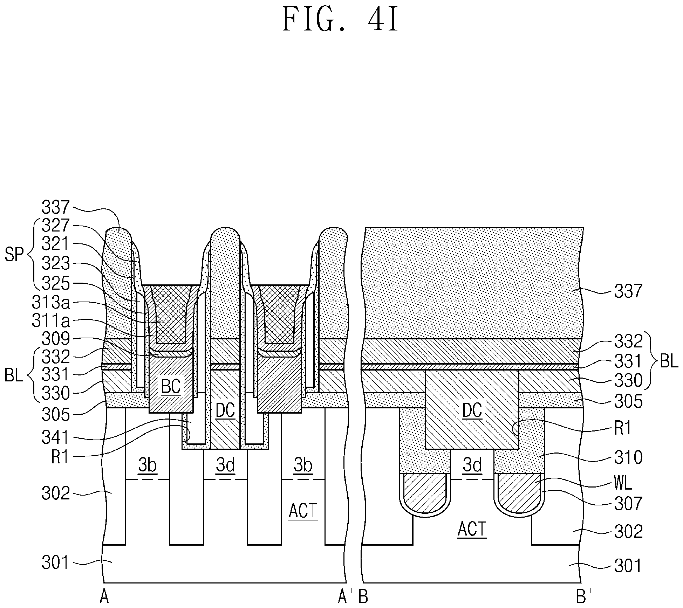

Referring to FIG. 4I, an anisotropic etching process or an etch-back process may be performed on the first pad layer 313 and the diffusion barrier layer 311 to expose an upper surface of the bit line capping pattern 337 and a side surface of the fourth spacer 327. Accordingly, diffusion barrier patterns 311a and first pad patterns 313a may be formed between the bit line capping patterns 337. Through this process, the diffusion barrier patterns 311a may be spaced apart from each other such that they do not cover the upper surface of the bit line capping pattern 337, thereby preventing a bridge between the diffusion barrier patterns 311a. This may reduce or prevent process defects and may improve yield.

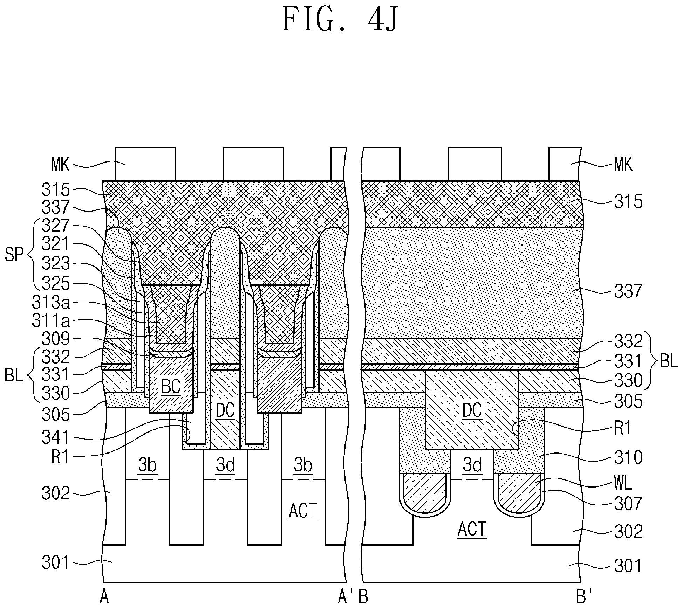

Referring to FIG. 4J, a second pad layer 315 is formed on the entire surface of the substrate 301. The second pad layer 315 may be formed of a first metal constituting the first pad pattern 313a. The second pad layer 315 may be formed through a sputtering process or physical vapor deposition (PVD). As the sputtering process is a process of physically separating and depositing first metal atoms from a target formed of the first metal, the second pad layer 315 may include only pure first metal atoms and may exclude chlorine atoms. As described above, when the second pad layer 315 excludes chlorine atoms, an electrical resistance may be further lowered, and thus an operating speed of the semiconductor memory device may be improved.

In another example, the second pad layer 315 may be formed through a CVD process and may include chlorine atoms. In this case, a content of chlorine atoms in the second pad layer 315 may be different from (e.g. less than) a content of chlorine atoms in the first pad pattern 313a by changing process conditions. A planarization operation may be performed by performing a CMP process on the second pad layer 315. A second mask pattern MK is formed on the second pad layer 315 to define a planar shape of the landing pad LP. The second mask patterns MK may be formed to vertically overlap the storage node contacts BC.

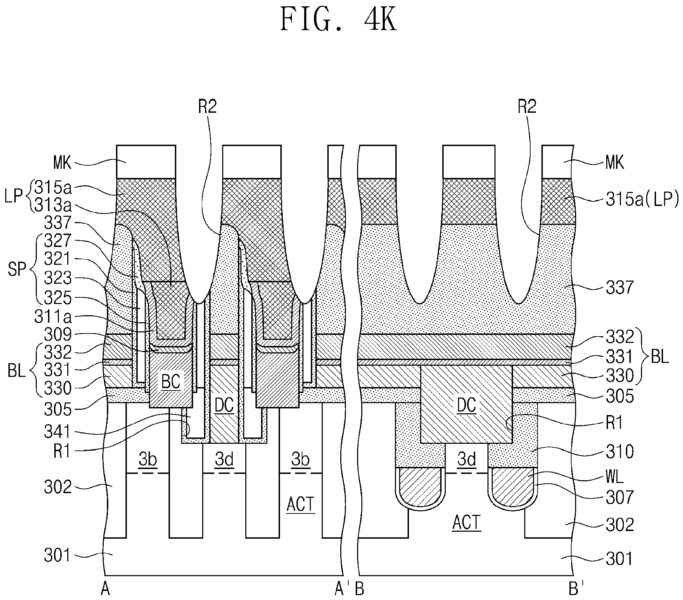

Referring to FIG. 4K, an anisotropic etching process may be performed to remove a portion of the second pad layer 315 using the second mask patterns MK as an etching mask, to form landing pads LP and to form second recess regions R2 exposing the diffusion barrier pattern 311a, simultaneously. A portion of the bit line capping pattern 337 and the fourth spacer 327 may be removed through the anisotropic etching process to expose an upper surface of the second spacer 323.

Again, referring to FIG. 2, the second mask pattern MK is removed. The landing pad separation pattern LIP is formed by filling the second recess regions R2 with an insulating material. A data storage pattern DSP is formed on the landing pad LP. As a result, the semiconductor memory device of FIGS. 1 and 2 may be fabricated.

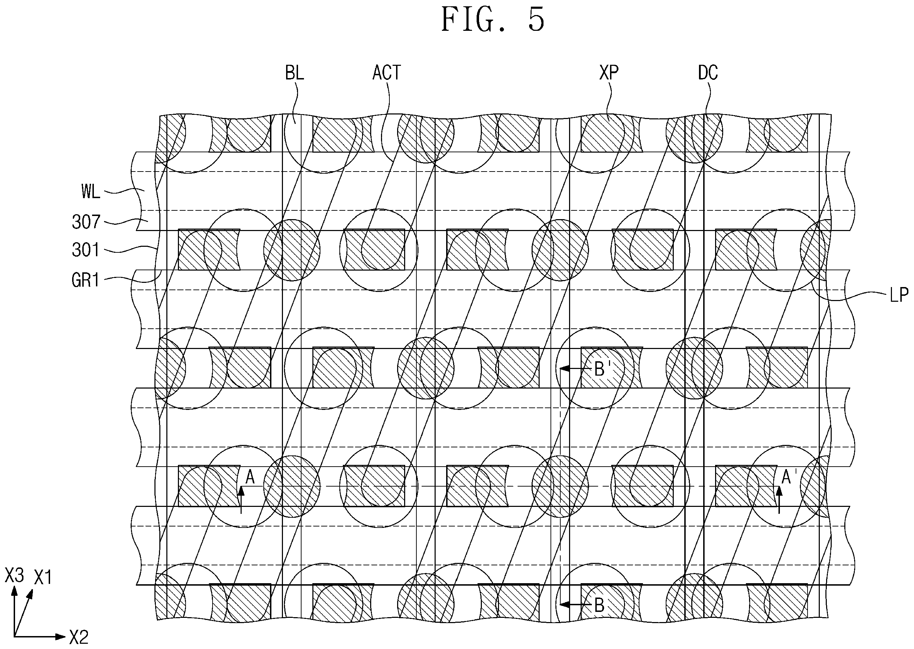

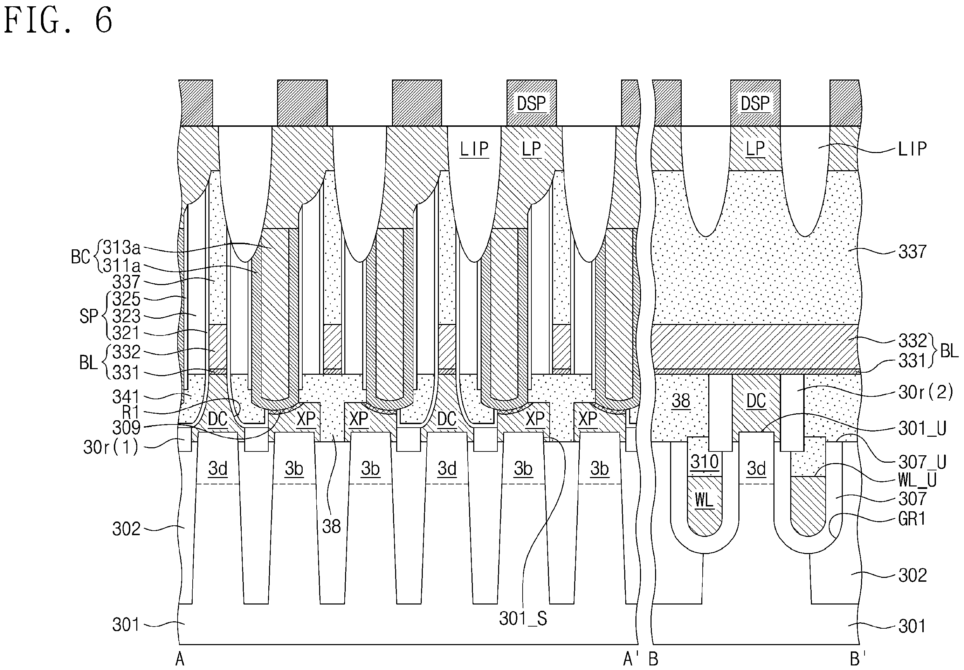

FIG. 5 is a plan view of a semiconductor memory device according to embodiments of the present disclosure. FIG. 6 is a cross-sectional view of FIG. 5 taken along lines A-A' and lines B-B'.

Referring to FIGS. 5 and 6, device isolation patterns 302 may be disposed on a substrate 301 to define active portions ACT. Upper surfaces of the device isolation patterns 302 may be lower than upper surfaces 301_U of the active portions ACT (or of the substrate 301). As a result, the device isolation patterns 302 may expose sidewalls 301_S of the active portions ACT (or of the substrate 301). That is, upper portions of the active portions ACT may protrude from the device isolation patterns 302.

Word lines WL may cross the active portions ACT. The word lines WL may be disposed in grooves GR1 formed in the device isolation patterns 302 and the active portions ACT. A gate dielectric layer 307 may be disposed between each of the word lines WL and an inner surface of each of the grooves GR1. Although not shown, bottoms of the grooves GR1 may be relatively deep within the device isolation patterns 302 and relatively shallow within the active portions ACT. Lower surfaces of the word lines WL may be curved. An upper surface 307_U of the gate dielectric layer 307 may be lower than the upper surfaces 301_U of the active portions ACT (or of the substrate 301). For example, the upper surface 307_U of the gate dielectric layer 307 may be positioned at the same level as the upper surfaces of the device isolation patterns 302.

Upper surfaces WL_U of the word lines WL may be lower than the upper surfaces 301_U of the active portions ACT (or of the substrate 301). An upper surface of the word line capping pattern 310 may be higher than an upper surface 307_U of the gate dielectric layer 307 and/or upper surfaces of the device isolation patterns 302.

A bit line BL may include a first metal pattern 331 and a second metal pattern 332 sequentially stacked. The bit line BL may exclude the bit line polysilicon pattern 330 of FIG. 2. A bit line contact DC may be disposed between the bit line BL and the active portion ACT doped with the first impurity region 3d. The bit line contact DC may include, for example, polysilicon doped with impurities. As shown in FIG. 5, the bit line contact DC may have a circular or elliptical shape when viewed in a plan view. A planar area of the bit line contact DC may be greater than an overlapping area between one bit line and one first impurity region 3d. The planar area of the bit line contact DC may be greater than a planar area of one of the first impurity regions 3d. Referring to FIG. 6, a lower width of the bit line contact DC may be wider than an upper width of the bit line contact DC. The bit line contact DC may cover a side surface of the first impurity region 3d. Due to the structure of the bit line contact DC, a contact area between the bit line contact DC and the first impurity region 3d may be increased, thereby reducing contact resistance, improving operating speed, and operating at lower power.

A storage node pad XP may be disposed on the active region ACT doped with the second impurity region 3b. The storage node pad XP may include, for example, polysilicon doped with impurities. The storage node pads XP of FIGS. 5 and 6 may correspond to the storage node contacts BC of FIGS. 1 and 2.

The storage node pad XP may have a shape similar to a rectangle as shown in FIG. 5 when viewed in a plan view. A sidewall of the storage node pad XP adjacent to the bit line contact DC may be recessed in a direction away from the bit line contact DC (in the second direction X2). A planar area of the storage node pad XP may be greater than that of one second impurity region 3b. The storage node pad XP may cover at least two sidewalls of the active portion ACT doped with the second impurity region 3b, opposite to each other in the second direction X2. An area where the storage node pad XP and the second impurity region 3b come into contact with the doped active region ACT may increase, thereby reducing contact resistance, improving operating speed, and operating at lower power.

A contact insulation pattern 30r may be interposed between the bit line contact DC and the storage node pad XP adjacent thereto. The contact insulation pattern 30r may be formed of an insulating material, and may include silicon oxide. The contact insulation pattern 30r may have a donut or annular shape when viewed in a plan view and may surround the bit line contact DC. A portion of the contact insulation pattern 30r may extend below the bit line BL as shown in the B-B' section of FIG. 6. The contact insulating pattern 30r may include a first insulating portion 30r(1) between the bit line contact DC and the storage node pad XP adjacent thereto and a second insulating portion 30r(2) under the bit line BL. A height of the second insulating portion 30r(2) may be greater than that of the first insulating portion 30r(1). A lower surface of the contact insulation pattern 30r may be positioned at the same level as or lower than an upper surface of the device isolation pattern 302.

Sidewalls of the bit line BL and the bit line capping pattern 337 may be covered by the spacer structure SP. The spacer structure SP may include the first to third spacers 321, 323, and 325 but may exclude the fourth spacer 327 of FIG. 2.

A recess region R1 may be defined by a sidewall of the bit line contact DC, an upper surface of the contact insulation pattern 30r, and a sidewall of the storage node pad XP. A lower buried insulating pattern 341 may fill the recess region R1. A lower end of the third spacer 325 may be lower than a lower end of the second spacer 323.

A pad separation pattern 38 is interposed between adjacent storage node pads XP. The pad separation pattern 38 may extend to cover upper surfaces of the storage node pads XP. The pad separation pattern 38 may be an insulating material and may include, for example, silicon nitride. In the cross-section B-B' of FIG. 6, the pad separation pattern 38 may be also disposed under the bit line BL, and may be in contact with a sidewall of the second insulating portion 30r(2) of the contact insulation pattern 30r, an upper surface of the word line capping pattern 310, an upper surface 307_U of the gate dielectric layer 307, and an upper surface of the device isolation pattern 302. The pad separation pattern 38 may be in contact with the lower surface of the bit line BL.

The storage node contact BC may include a diffusion barrier pattern 311a and a first pad pattern 313a. The diffusion barrier pattern 311a covers the sidewall and lower surface of the first pad pattern 313a. A storage node ohmic layer 309 may be interposed between the storage node contact BC and the storage node pad XP. Landing pads LP may be positioned on the storage node contacts BC, respectively. The landing pads LP and the first pad pattern 313a may include the same material as each other. The landing pads LP of FIG. 6 may correspond to the second pad pattern 315a of FIG. 2. The landing pads LP may cover an upper surface of the diffusion barrier pattern 311a, an upper sidewall of the spacer structure SP, and an upper surface of the bit line capping pattern 337. Other structures may be the same/similar to those described with reference to FIGS. 1 and 2.

In the semiconductor memory device according to the present disclosure, the upper ends of the diffusion barrier patterns between the bit lines are lower than the upper ends of the bit line capping patterns. Accordingly, it is possible to prevent the bridging between the adjacent landing pads by the diffusion barrier pattern. Accordingly, the operation error of the semiconductor memory device may be reduced or prevented and the semiconductor memory device with the improved reliability may be provided.

In the method of fabricating the semiconductor memory device according to the present disclosure, the landing pad may be formed in a dual structure of the first pad pattern and the second pad pattern. The diffusion barrier layer may be anisotropically etched before the forming of the second pad pattern to form the diffusion barrier patterns spaced apart from each other. Accordingly, the bridging may be prevented between the diffusion barrier patterns to reduce or prevent process defects and to improve yield.

Spatially relative terms such as 'over,' above, ' 'upper,' 'upper portion,' 'upper surface,' 'below,' 'lower,' 'lower portion,' 'lower surface,' 'side surface,' and the like may be described relative to a reference (e.g., a substrate), but are intended to encompass different orientations of the device in use or operation in addition to the orientation depicted in the figures. For example, if the device in the figures is turned over, elements described as "below" or "beneath" other elements or features would then be oriented "above" the other elements or features. The device may be otherwise oriented (rotated 90 degrees or at other orientations), and the spatially relative descriptors used herein may be interpreted accordingly.

While embodiments are described above, a person skilled in the art may understand that many modifications and variations are made without departing from the spirit and scope of the present disclosure defined in the following claims. Accordingly, the example embodiments of the present disclosure should be considered in all respects as illustrative and not restrictive, with the scope of the present disclosure being indicated by the appended claims. The embodiments of FIGS. 1 through 6 can be combined with each other in various ways.

Further embodiments are set out in the following clauses:
1. A semiconductor memory device comprising:
   a substrate having active portions extending in a first direction, the active portions comprising first and second impurity regions at central and edge portions thereof, respectively;
   a device isolation pattern in the substrate between the active portions;
   a first bit line connected to at least one of the first impurity regions and extending over the active portions in a second direction that intersects the first direction;
   a second bit line spaced apart from the first bit line in a third direction that intersects the first and second directions;
   first and second bit line capping patterns on the first and second bit lines, respectively;
   a storage node contact between the first bit line and the second bit line and in contact with one of the second impurity regions;
   a diffusion barrier layer on a sidewall of the first bit line, on a sidewall of the second bit line, and on an upper surface of the storage node contact therebetween; and
   a landing pad on the diffusion barrier layer,
   wherein a first upper end of the diffusion barrier layer on the sidewall of the first bit line is lower than the first bit line capping pattern, relative to the substrate, and
   wherein a second upper end of the diffusion barrier layer on the sidewall of the second bit line is lower than the first upper end, relative to the substrate.
2. The semiconductor memory device of clause 1, further comprising a spacer structure between the first bit line and the diffusion barrier layer,
   wherein the spacer structure comprises:
   a first spacer on the sidewall of the first bit line and on a sidewall of the first bit line capping pattern,
   a second spacer on a lower side surface of the first spacer, wherein an upper side surface of the first spacer is free of the second spacer,
   a third spacer on a side surface of the second spacer; and
   a fourth spacer on the upper side surface of the first spacer and in contact with an upper surface of the second spacer,
   wherein an upper end of the second spacer is lower than the first upper end of the diffusion barrier layer, relative to the substrate.
3. The semiconductor memory device of clause 1 or clause 2, wherein the landing pad comprises:
   a first pad portion on the diffusion barrier layer; and
   a second pad portion on the first pad portion and in contact with the first bit line capping pattern,
   wherein the first pad portion comprises chlorine atoms, and the second pad portion is free of chlorine atoms.
4. The semiconductor memory device of clause 3, wherein the first pad portion comprises first metal grains having a first average size, and
   wherein the second pad portion comprises second metal grains having a second average size smaller than the first average size.

5. The semiconductor memory device of clause 3 or clause 4, wherein the second pad portion extends between an upper sidewall of the first pad portion and the first bit line capping pattern.
6. The semiconductor memory device of clause 3 or clause 4, wherein the first upper end of the diffusion barrier layer extends between the second pad portion and the first bit line capping pattern.
7. The semiconductor memory device of clause 1 or clause 2, wherein the landing pad comprises:
   a first pad portion on the diffusion barrier layer; and
   a second pad portion on the first pad portion and in contact with the first bit line capping pattern,
   wherein the first pad portion and the second pad portion comprise a first concentration of chlorine atoms and a second concentration of chlorine atoms, respectively, and
   wherein the first concentration is different from the second concentration.
8. The semiconductor memory device of any preceding clause, wherein the first upper end of the diffusion barrier layer has a substantially planar or concave upper surface.
9. A semiconductor memory device comprising:
   a substrate having active portions that extend in a first direction, the active portions comprising first and second impurity regions at central and edge portions thereof, respectively;
   a device isolation pattern in the substrate between the active portions;
   a first bit line connected to at least one of the first impurity regions and extending over the active portions in a second direction that intersects the first direction;
   a second bit line spaced apart from the first bit line in a third direction that intersects the first and second directions;
   first and second bit line capping patterns on the first and second bit lines, respectively;
   a storage node contact between the first bit line and the second bit line and in contact with one of the second impurity regions;
   a diffusion barrier layer on a sidewall of the first bit line, on a sidewall of the second bit line, and on an upper surface of the storage node contact therebetween, wherein upper sidewalls of the first and second bit line capping patterns are free of the diffusion barrier layer; and
   a landing pad on the diffusion barrier layer,
   wherein the landing pad comprises:
      a first pad portion on the diffusion barrier layer; and
      a second pad portion on the first pad portion and in contact with the first bit line capping pattern,
      wherein the first pad portion comprises chlorine atoms, and
      wherein the second pad portion is free of chlorine atoms.
10. The semiconductor memory device of clause 9,
   wherein a first upper end of the diffusion barrier layer on the sidewall of the first bit line is lower than the first bit line capping pattern, relative to the substrate, and
   wherein a second upper end of the diffusion barrier layer on the sidewall of the second bit line is lower than the first upper end, relative to the substrate.
11. The semiconductor memory device of clause 10, further comprising a spacer structure between the first bit line and the diffusion barrier layer,
   wherein the spacer structure comprises:
   a first spacer on the sidewall of the first bit line and on a sidewall of the first bit line capping pattern;
   a second spacer on a lower side surface of the first spacer, wherein an upper side surface of the first spacer is free of the second spacer;
   a third spacer on a side surface of the second spacer; and
   a fourth spacer on the upper side surface of the first spacer and in contact with an upper surface of the second spacer,
   wherein an upper end of the second spacer is lower than the first upper end of the diffusion barrier layer, relative to the substrate.
12. The semiconductor memory device of any of clauses 9-11, wherein the first pad portion comprises first metal grains having a first average size, and
   wherein the second pad portion comprises second metal grains having a second average size smaller than the first average size.
13. The semiconductor memory device of any of clauses 9-12, wherein the second pad portion extends between an upper sidewall of the first pad portion and the first bit line capping pattern.
14. The semiconductor memory device of any of clauses 9-12, wherein the diffusion barrier layer extends between the second pad portion and the first bit line capping pattern.
15. The semiconductor memory device of any of clauses 9-14, wherein an upper surface of the diffusion barrier layer is substantially planar or concave.
16. A semiconductor memory device comprising:
   a substrate having active portions extending in a first direction, the active portions comprising first and second impurity regions at central and edge portions thereof, respectively;
   a device isolation pattern in the substrate between the active portions;
   word lines in the substrate and intersecting the active portions in a second direction that intersects the first direction;
   word line capping patterns on the word lines;
   a first bit line connected to at least one of the first impurity region and extending over the word lines in a third direction that intersects the first and second directions;
   a second bit line spaced apart from the first bit line in the second direction;
   first and second bit line capping patterns on the first and second bit lines, respectively;
   a storage node contact between the first bit line and the second bit line and in contact with one of the second impurity regions;
   a diffusion barrier layer on a sidewall of the first bit line, on a sidewall of the second bit line, and on an upper surface of the storage node contact therebetween, wherein upper sidewalls of the first and second bit line capping patterns are free of the diffusion barrier layer; and a landing pad on the diffusion barrier layer,
   wherein the landing pad comprises:
   a first pad portion on the diffusion barrier layer; and
   a second pad portion on the first pad portion and in contact with the first bit line capping pattern;
   wherein the first pad portion comprises first metal grains having a first average size, and
   wherein the second pad portion comprises second metal grains having a second average size smaller than the first average size.
17. The semiconductor memory device of clause 16, wherein the first pad portion comprises chlorine atoms, and
   wherein the second pad portion is free of chlorine atoms.
18. The semiconductor memory device of clause 16 or clause 17,
   wherein a first upper end of the diffusion barrier layer on the sidewall of the first bit line is lower than the first bit line capping pattern, relative to the substrate, and
   wherein a second upper end of the diffusion barrier layer on the sidewall of the second bit line is lower than the first upper end, relative to the substrate.
19. The semiconductor memory device of clause 18, further comprising a spacer structure between the first bit line and the diffusion barrier layer,
   wherein the spacer structure comprises:
   a first spacer on the sidewall of the first bit line and on a sidewall of the first bit line capping pattern;
   a second spacer on a lower side surface of the first spacer, wherein an upper side surface of the first spacer is free of the second spacer;
   a third spacer on a side surface of the second spacer; and
   a fourth spacer on the upper side surface of the first spacer and in contact with an upper surface of the second spacer,
   wherein an upper end of the second spacer is lower than the first upper end of the diffusion barrier layer, relative to the substrate.
20. The semiconductor memory device of any of clauses 16-19, wherein an upper surface of the diffusion barrier layer is substantially planar or concave.
21. A method of fabricating a semiconductor memory device, the method comprising:
   forming a device isolation pattern on a substrate to define active portions;
   forming first impurity regions and second impurity regions in the active portions;
   forming bit lines on the substrate extending over the active portions and in contact with at least one of the first impurity regions;
   forming bit line capping patterns on the bit lines;
   forming spacer structures on sidewalls of the bit lines and the bit line capping patterns;
   forming storage node contacts between the bit lines and in contact with the second impurity regions, respectively;
   forming a diffusion barrier layer on the substrate after forming the spacer structures and the storage node contacts;
   forming a first pad layer on the diffusion barrier layer in spaces between the bit line capping patterns;
   performing an anisotropic etching process on the first pad layer and the diffusion barrier layer to form a diffusion barrier patterns and first pad patterns, wherein upper surfaces of the bit line capping patterns and upper sidewalls of the spacer structures are free of the diffusion barrier patterns;
   forming a second pad layer on the substrate after performing the anisotropic etching process; and
   patterning the second pad layer to form second pad patterns on the first pad patterns .
22. The method of clause 21, further comprising planarizing an upper surface of the first pad layer before the performing of the anisotropic etching process on the first pad layer and the diffusion barrier layer.
23. The method of clause 21 or clause 22, wherein the patterning of the second pad layer comprises removing portions of the bit line capping patterns, the spacer structures, the first pad patterns, and the diffusion barrier patterns.

## Claims

1. A semiconductor memory device comprising:
a substrate having active portions extending in a first direction, the active portions comprising first and second impurity regions at central and edge portions thereof, respectively;
a device isolation pattern in the substrate between the active portions;
a first bit line connected to at least one of the first impurity regions and extending over the active portions in a second direction that intersects the first direction;
a second bit line spaced apart from the first bit line in a third direction that intersects the first and second directions;
first and second bit line capping patterns on the first and second bit lines, respectively;
a storage node contact between the first bit line and the second bit line and in contact with one of the second impurity regions;
a diffusion barrier layer on a sidewall of the first bit line, on a sidewall of the second bit line, and on an upper surface of the storage node contact therebetween; and
a landing pad on the diffusion barrier layer,
wherein a first upper end of the diffusion barrier layer on the sidewall of the first bit line is lower than the first bit line capping pattern, relative to the substrate, and
wherein a second upper end of the diffusion barrier layer on the sidewall of the second bit line is lower than the first upper end, relative to the substrate.

2. The semiconductor memory device of claim 1, further comprising a spacer structure between the first bit line and the diffusion barrier layer,
wherein the spacer structure comprises:
a first spacer on the sidewall of the first bit line and on a sidewall of the first bit line capping pattern,
a second spacer on a lower side surface of the first spacer, wherein an upper side surface of the first spacer is free of the second spacer,
a third spacer on a side surface of the second spacer; and
a fourth spacer on the upper side surface of the first spacer and in contact with an upper surface of the second spacer,
wherein an upper end of the second spacer is lower than the first upper end of the diffusion barrier layer, relative to the substrate.

3. The semiconductor memory device of claim 1 or claim 2, wherein the landing pad comprises:
a first pad portion on the diffusion barrier layer; and
a second pad portion on the first pad portion and in contact with the first bit line capping pattern,
wherein the first pad portion comprises chlorine atoms, and the second pad portion is free of chlorine atoms.

4. The semiconductor memory device of claim 1 or claim 2, wherein the landing pad comprises:
a first pad portion on the diffusion barrier layer; and
a second pad portion on the first pad portion and in contact with the first bit line capping pattern,
wherein the first pad portion and the second pad portion comprise a first concentration of chlorine atoms and a second concentration of chlorine atoms, respectively, and
wherein the first concentration is different from the second concentration.

5. The semiconductor memory device of claim 3 or claim 4, wherein the first pad portion comprises first metal grains having a first average size, and
wherein the second pad portion comprises second metal grains having a second average size smaller than the first average size.

6. The semiconductor memory device of any of claims 3-5, wherein the second pad portion extends between an upper sidewall of the first pad portion and the first bit line capping pattern.

7. The semiconductor memory device of any of claims 3-5, wherein the first upper end of the diffusion barrier layer extends between the second pad portion and the first bit line capping pattern.

8. The semiconductor memory device of any preceding claim, wherein the first upper end of the diffusion barrier layer has a substantially planar or concave upper surface.
